# EUROPEAN PATENT APPLICATION

(11) **EP 4 459 659 A1**
(43) Date of publication of application: **06.11.2024**
(21) Application number: 22915474.5
(22) Date of filing: 19.10.2022
(51) Int. Cl.: H01L 21/02, H01L 21/304

(54) **OPERATION MONITORING METHOD AND MANUFACTURING DEVICE**

(30) Priority: 27.12.2021 JP 2021212535
(71) Applicant: SCREEN Holdings Co., Ltd., Kyoto-shi, Kyoto 602-8585 (JP)
(72) Inventor: OKAMOTO, Satoshi, Kyoto-shi, Kyoto 602-8585 (JP); FURUTA, Tomoyasu, Kyoto-shi, Kyoto 602-8585 (JP)
(74) Representative: Goddar, Heinz J.
(86) International application number: PCT/JP2022/038943
(87) International publication number: WO 2023/127239

(57) **Abstract**

The present invention provides a technique for evaluating variations in the operation of a processing unit for each pixel. First, a plurality of moving images (M) are acquired by shooting, a plurality of times, a specific operation of the processing unit. Then, a motion vector (V) is calculated for each pixel by an optical flow method for a plurality of frame images (F) included in the plurality of moving images (M). Then, an evaluation value (σ) is calculated based on the motion vector (V) for each pixel by comparing the motion vectors (M) calculated for the same pixel at the same time in the plurality of moving images (M). Thereafter, the specific operation of the processing unit is evaluated in accordance with the calculated evaluation value (σ).

## Description

### [Technical Field]

The present invention relates to an operation monitoring method of monitoring an operation of a processing unit and a manufacturing apparatus including the processing unit.

### [Background Art]

The reproducibility of operations is an important issue for apparatuses such as industrial machinery. In particular, in apparatuses such as semiconductor manufacturing apparatuses that perform precision machining and micromachining on substrates, slight discrepancies in operation can be a cause of significant degradation of product quality. There is thus demand for quantitative evaluation of slight variations in operations to be performed by apparatuses.

Technology is conventionally known in which an apparatus is provided with a camera to monitor anomalies in operation. For example, Patent Literature (PTL) 1 discloses a technique for shooting a process for processing substrates by a camera and detecting the occurrence of anomalies in accordance with the captured moving image.

### [Citation List]

### [Patent Literature]

### [PTL 1]

Japanese Patent Application Laid-Open No. 2014-165607

### [Summary of Invention]

### [Technical Problem]

The technique disclosed in PTL 1 is, however, merely to detect sudden or irregular occurrence of anomalies for each frame of the moving image. Thus, it is not possible with the method disclosed in PTL 1 to evaluate, for each pixel, the reproducibility of operations repeated multiple times in an apparatus.

The present invention has been made in light of such circumstances, and it is an object of the present invention to provide a technique for evaluating variations in the operation of a processing unit for each pixel.

### [Solution to Problem]

To solve the problem described above, a first aspect of the present application is an operation monitoring method of monitoring an operation of a processing unit. The operation monitoring method includes a) acquiring a plurality of moving images by shooting, a plurality of times, a specific operation of the processing unit, b) calculating a motion vector for each pixel by an optical flow for a plurality of frame images included in the plurality of moving images, c) calculating an evaluation value based on the motion vector for each pixel by comparting the motion vectors calculated for the same pixel at the same time in the plurality of moving images, and d) evaluating the specific operation of the processing unit in accordance with the evaluation value.

A second aspect of the present application is the operation monitoring method according to the first aspect, in which the evaluation value is a standard deviation of the motion vector obtained by using, as a population, the motion vectors calculated for the same pixel at the same time in the plurality of moving images.

A third aspect of the present application is the operation monitoring method according to the second aspect, in which the plurality of frame images are two-dimensional images defined by an x axis and a y axis, the operation c) includes calculating a standard deviation of an x-axis component of the motion vector and a standard deviation of a y-axis component of the motion vector, and in the operation d), the specific operation of the processing unit is evaluated in accordance with an average value of the standard deviation of the x-axis component and the standard deviation of the y-axis component.

A fourth aspect of the present application is the operation monitoring method according to any one of the first to third aspects further includes x) calculating a feature based on the motion vector for each of the plurality of frame images in each of the plurality of moving images, and y) synchronizing timing of the plurality of moving images with one another in accordance with a time-varying waveform of the feature. The operation x) and the operation y) are performed after the operation b) and before the operation c).

A fifth aspect of the present application is the operation monitoring method according to the fourth aspect, in which the feature is an average value of lengths of the motion vectors for a plurality of pixels included in the plurality of frame images.

A sixth aspect of the present application is the operation monitoring method according to any one of the first to fifth aspects, in which the operation d) includes, when the evaluation value deviates from a preset tolerance, outputting an evaluation result indicating that the specific operation exhibits a wide range of variations.

A seventh aspect of the present application is the operation monitoring method according to any one of the first to fifth aspects, in which in the operation a), the plurality of moving images are acquired by shooting, the plurality of times, the specific operation for each of a processing unit that serves as a reference and a different processing unit, and the operation d) includes, when a difference between the evaluation value calculated for the processing unit serving as the reference and the evaluation value calculated for the different processing unit deviates from a preset tolerance, outputting an evaluation result indicating that the specific operation of the different processing unit exhibits a wide range of variations.

An eighth aspect of the present application is the operation monitoring method according to the sixth or seventh aspect, in which in the outputting of the evaluation result, a pixel whose evaluation value deviates from the preset tolerance in the plurality of frame images is displayed with a color, a character, or a graphic overlaid on the pixel.

A ninth aspect of the present application is the operation monitoring method according to any one of the first to eighth aspects, in which the processing unit is a unit that supplies a processing liquid to a surface of a substrate.

A tenth aspect of the present application is a manufacturing apparatus that includes a processing unit that processes a target object by performing a specific operation, a camera that captures a moving image of the specific operation of the processing unit, and a computer that evaluates the specific operation in accordance with the moving image obtained from the camera. The manufacturing apparatus causes the computer to execute a) processing for acquiring a plurality of moving images by causing the camera to shoot, a plurality of times, the specific operation of the processing unit, b) processing for calculating a motion vector for each pixel by an optical flow method for a plurality of frame images included in the plurality of moving images, c) processing for calculating an evaluation value in accordance with the motion vector for each pixel by comparing the motion vectors calculated for the same pixel at the same time in the plurality of moving images, and d) processing for evaluating the specific operation of the processing unit in accordance with the evaluation value.

### [Advantageous Effects of the Invention]

According to the first to tenth aspects of the present application, it is possible to evaluate variations in the specific operation of the processing unit for each pixel in accordance with the motion vector.

In particular, according to the fourth aspect of the present application, it is possible to synchronize the timing of the plurality of moving images with one another. This allows variations in the specific operation of the processing unit to be evaluated accurately in the operations c) and d). Besides, the feature for use in synchronizing the timing of the plurality of moving images with one another is calculated based on the motion vector. This eliminates the need to measure, separately from the motion vector, other parameters for use in synchronizing the timing of the plurality of moving images with one another.

In particular, according to the eighth aspect of the present application, it is possible to facilitate visual grasping of a portion where the specific operation exhibits a wider range of variations.

### [Brief Description of Drawings]

Fig. 1 is a plan view of a substrate processing apparatus.
Fig. 2 is a longitudinal sectional view of one processing unit.
Fig. 3 is a diagram schematically showing how a camera captures an image.
Fig. 4 is a block diagram showing connection between a controller and each constituent element of a processing unit.
Fig. 5 is a flowchart showing a procedure for processing a substrate.
Fig. 6 is a flowchart showing a procedure for operation monitoring.
Fig. 7 is a diagram schematically showing a configuration of one moving image.
Fig. 8 is a diagram showing an example of one frame image.
Fig. 9 is a diagram showing an example of a motion vector calculated for one frame image.
Fig. 10 is a graph showing an example of time-varying waveforms of features calculated for two moving images.
Fig. 11 is a diagram schematically showing processing for calculating standard deviations.
Fig. 12 is a diagram showing an example of an evaluation result.

### [Description of Embodiment]

Hereinafter, an embodiment of the present invention will be described in detail with reference to the drawings.

### 1. Overall Configuration of Substrate Processing Apparatus

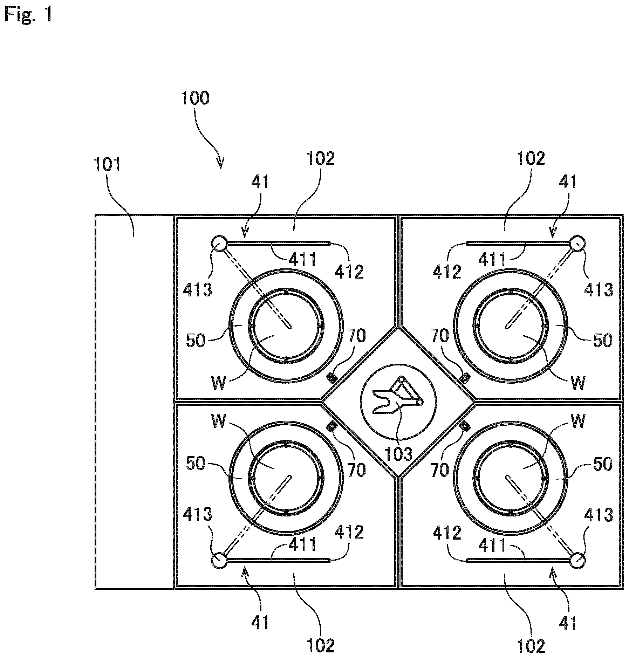

Fig. 1 is a plan view of a substrate processing apparatus 100 as an example of a manufacturing apparatus according to the present invention. The substrate processing apparatus 100 is an apparatus for processing surfaces of disk-like substrates W (silicon wafers) by supplying a processing liquid to the surfaces of the substrates W during the process of manufacturing the semiconductor wafers. As shown in Fig. 1, the substrate processing apparatus 100 includes an indexer 101, a plurality of processing units 102, and a main transport robot 103.

The indexer 101 is a part for transporting unprocessed substrates W into the apparatus from the outside and transporting processed substrates W to the outside of the apparatus. The indexer 101 includes a plurality of carriers arranged therein, each carrier housing therein a plurality of substrates W. The indexer 101 also includes a transfer robot which is not shown. The transfer robot transfers substrates W between the carriers in the indexer 101 and either the processing units 102 or the main transport robot 103.

Each processing unit 102 is a so-called sheet-fed processing part for processing substrates W one by one. The processing units 102 are arranged around the main transport robot 103. In the present embodiment, three layers of processing units 102 are stacked one above another in a height direction, each layer including four processing units 102 arranged around the main transport robot 103. That is, the substrate processing apparatus 100 according to the present embodiment includes 12 processing units 102 in total. Each processing unit 102 processes a plurality of substrates W in parallel. It is, however, noted that the number of processing units 102 included in the substrate processing apparatus 100 is not limited to 12, and may be any number such as 1, 4, 8, or 24.

The main transport robot 103 is a mechanism for transporting substrates W between the indexer 101 and the processing units 102. For example, the main transport robot 103 may include a hand for holding a substrate W and an arm for moving the hand. The main transport robot 103 takes unprocessed substrates W out of the indexer 101 and transfers these substrates W to the processing units 102. When the processing units 102 have completed the processing of the substrates W, the main transport robot 103 takes the processed substrates W out of the processing units 102 and transfers these substrates W to the indexer 101.

### 2. Configuration of Processing Unit

Next is a description of a detailed configuration of the processing units 102. While the following description is given about one of the processing units 102 included in the substrate processing apparatus 100, the other processing units 102 also have equivalent configurations.

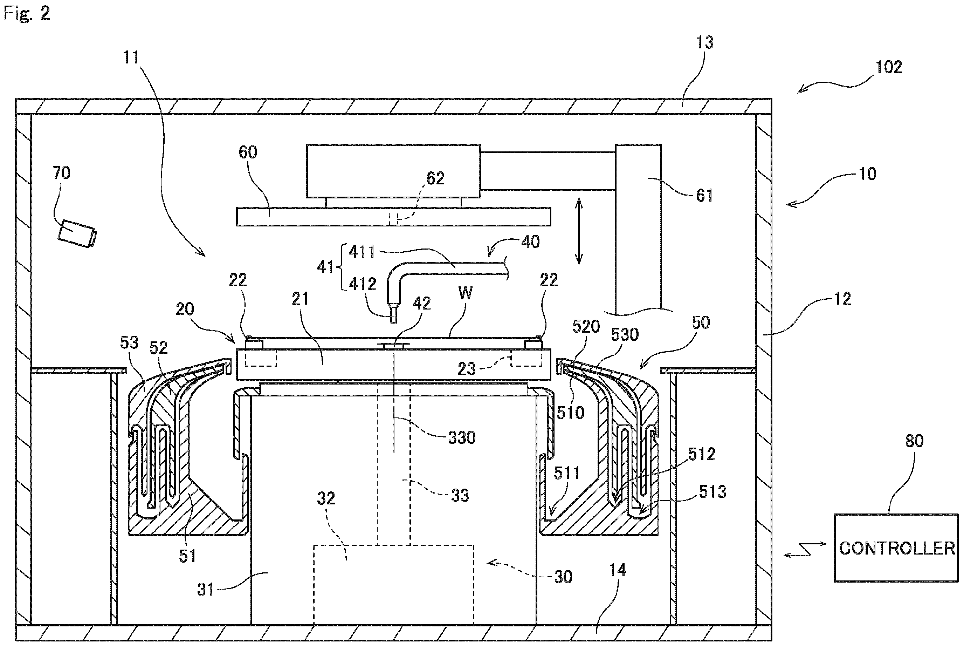

Fig. 2 is a longitudinal sectional view of one processing unit 102. As shown in Fig. 2, the processing unit 102 includes a chamber 10, a substrate holder 20, a rotation mechanism 30, a processing liquid supplier 40, a processing liquid collector 50, a barrier plate 60, a camera 70, and a controller 80.

The chamber 10 is a casing that has a processing space 11 for processing substrates W. The chamber 10 has a side wall 12 that surrounds the sides of the processing space 11, a top plate 13 that covers the top of the processing space 11, and a bottom plate 14 that covers the bottom of the processing space 11. The substrate holder 20, the rotation mechanism 30, the processing liquid supplier 40, the processing liquid collector 50, the barrier plate 60, and the camera 70 are housed in the chamber 10. The side wall 12 is provided with a transport entrance and a shutter, the transport entrance being an entrance for transporting substrates W into and out of the chamber 11, the shutter being a mechanism for opening and closing the transport entrance.

The substrate holder 20 is a mechanism for holding substrates W horizontally (in such a posture that the normal is oriented in the vertical direction) inside the chamber 10. As shown in Fig. 2, the substrate holder 20 includes a disk-like spin base 21 and a plurality of chuck pins 22. The chuck pins 22 are provided at equiangular intervals along the outer periphery of the upper surface of the spin base 21. The substrate W is held by the chuck pins 22 so that its surface to be processed where a pattern is formed faces upward. Each chuck pin 22 comes in contact with the lower surface of the edge portion of the substrate W and with the outer peripheral end face of the substrate W and supports the substrate W at a position above the upper surface of the spin base 21 with a slight gap therebetween.

The spin base 21 includes a chuck-pin switching mechanism 23 for switching the positions of the chuck pins 22. The chuck-pin switching mechanism 23 switches the chuck pins 22 between a holding position at which the chuck pins 22 hold the substrate W and a release position at which the chuck pins 22 release the hold of the substrate W.

The rotation mechanism 30 is a mechanism for rotating the substrate holder 20. The rotation mechanism 30 is housed in a motor cover 31 provided below the spin base 21. As indicated by broken lines in Fig. 2, the rotation mechanism 30 includes a spin motor 32 and a support shaft 33. The support shaft 33 extends in the vertical direction and has its lower end connected to the spin motor 32 and its upper end fixed to the center of the lower surface of the spin base 21. When the spin motor 32 is driven, the support shaft 33 rotates about the shaft center 330. Together with the support shaft 33, the substrate holder 20 and the substrate W held by the substrate holder 20 also rotate about the shaft center 330.

The processing liquid supplier 40 is a mechanism for supplying a processing liquid to the upper surface of the substrate W held by the substrate holder 20. The processing liquid supplier 40 includes a top nozzle 41 and a bottom nozzle 42. As shown in Figs. 1 and 2, the top nozzle 41 includes a nozzle arm 411, a nozzle head 412 provided at the tip of the nozzle arm 411, and a nozzle motor 413. The nozzle arm 411 is driven by the nozzle motor 413 so as to move angularly in the horizontal direction about the root end of the nozzle arm 411. This allows the nozzle head 412 to move between a processing position located above the substrate W held by the substrate holder 20 (positions indicated by chain double-dashed lines in Fig. 1) and a retracted position located outward of the processing liquid collector 50 (positions indicated by solid lines in Fig. 1).

The nozzle head 412 is connected to a liquid supplier (not shown) for supplying a processing liquid. Examples of the processing liquid that may be used include an SPM cleaning liquid (a mixed solution of a sulfuric acid and hydrogen peroxide water), an SC-1 cleaning liquid (a mixed solution of aqueous ammonia, hydrogen peroxide water, and pure water), an SC-2 cleaning liquid (a mixed solution of a hydrochloric acid, hydrogen peroxide water, and pure water), a DHF cleaning liquid (a dilute hydrofluoric acid), and pure water (deionized water). When a valve of the liquid supplier is opened with the nozzle head 412 placed at the processing position, the processing liquid supplied from the liquid supplier is ejected from the nozzle head 412 toward the upper surface of the substrate W held by the substrate holder 20.

Note that the nozzle head 412 may be a so-called two-fluid nozzle that mixes the processing liquid with a pressurized gas to generate droplets and ejects a resultant mixed fluid of the droplets and the pressurized gas to the substrate W. As another alternative, each processing unit 102 may include a plurality of top nozzles 41.

The bottom nozzle 42 is arranged inward of a through hole provided in the center of the spin base 21. The bottom nozzle 42 has an ejection outlet that faces the lower surface of the substrate W held by the substrate holder 20. The bottom nozzle 42 is also connected to the liquid supplier for supplying the processing liquid. When the processing liquid is supplied from the liquid supplier to the bottom nozzle 42, the bottom nozzle 42 ejects the processing liquid toward the lower surface of the substrate W.

The processing liquid collector 50 is a part for collecting the used processing liquid. As shown in Fig. 2, the processing liquid collector 50 includes an inner cup 51, an intermediate cup 52, and an outer cup 53. The inner cup 51, the intermediate cup 52, and the outer cup 53 are movable up and down independently of one another by means of an elevating mechanism which is not shown.

The inner cup 51 includes a circular ring-shaped first guide plate 510 that surrounds the periphery of the substrate holder 20. The intermediate cup 52 includes a circular ring-shaped second guide plate 520 that is located outward and upward of the first guide plate 510. The outer cup 53 includes a circular ring-shaped third guide plate 530 that is located outward and upward of the second guide plate 520. The bottom of the inner cup 51 extends to below the bottoms of the intermediate cup 52 and the outer cup 53. The upper surfaces of these bottoms are provided with a first drain groove 511, a second drain groove 512, and a third drain groove 513 in order from the inner side.

The processing liquid ejected from the top and bottom nozzles 41 and 42 of the processing liquid supplier 40 is supplied to the substrate W and then scattered to the outside by centrifugal force caused by rotation of the substrate W. Then, the processing liquid scattered from the substrate W is collected by one of the first guide plate 510, the second guide plate 520, and the third guide plate 530. The processing liquid collected by the first guide plate 510 is discharged through the first drain groove 511 to the outside of the processing unit 102. The processing liquid collected by the second guide plate 520 is discharged through the second drain groove 512 to the outside of the processing unit 102. The processing liquid collected by the third guide plate 530 is discharged through the third drain groove 513 to the outside of the processing unit 102.

In this way, the processing unit 102 includes a plurality of passages for discharging processing liquids. Thus, the processing unit 102 is capable of sorting and collecting processing liquids supplied to the substrate W for each type of processing liquid. Accordingly, collected processing liquids can also be separately disposed of or regenerated depending on the properties of each processing liquid.

The barrier plate 60 is a member for suppressing diffusion of a gas in the vicinity of the surface of the substrate W during certain processing such as dry processing. The barrier plate 60 has a disk-like outside shape and is arranged horizontally above the substrate holder 20. As shown in Fig. 2, the barrier plate 60 is connected to an elevating mechanism 61. When the elevating mechanism 61 is operated, the barrier plate 60 moves up and down between an upper position at which the barrier plate 60 is spaced above from the upper surface of the substrate W held by the substrate holder 20 and a lower position at which the barrier plate 60 is closer to the upper surface of the substrate W than when being at the upper position. For example, the elevating mechanism 61 may be a mechanism for converting rotational motion of a motor into translatory motion by means of a ball screw.

The barrier plate 60 has an air outlet 62 in the center of its lower surface, the air outlet 62 being an outlet from which a gas for drying (hereinafter, referred to as the "drying gas") is issued. The air outlet 62 is connected to a gas supplier (not shown) that supplies the drying gas. The drying gas may, for example, be a heated nitrogen gas.

When the processing liquid is supplied from the top nozzle 41 to the substrate W, the barrier plate 60 retracts to the upper position. When dry processing is performed on the substrate W after the supply of the processing liquid, the elevating mechanism 61 moves the barrier plate 60 down to the lower position. Then, the drying gas is issued from the air outlet 62 toward the upper surface of substrate W. At this time, the barrier plate 60 prevents the diffusion of the gas. As a result, the drying gas is efficiently supplied to the upper surface of the substrate W.

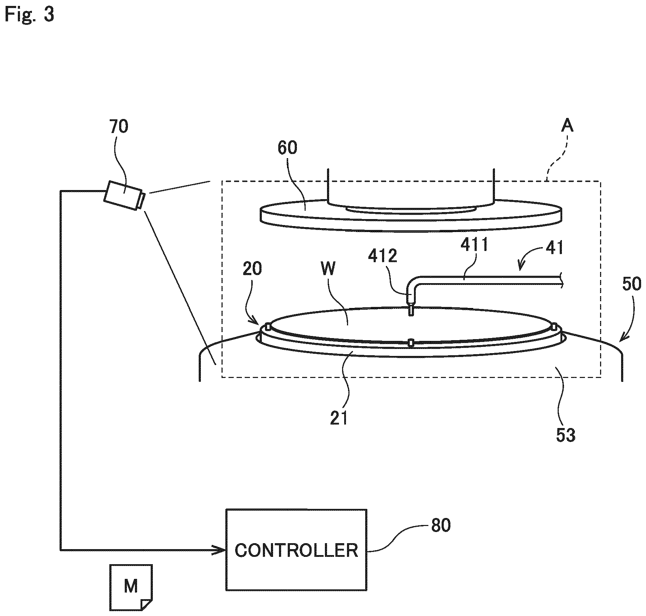

The camera 70 is a device that shoots a specific operation performed in the chamber 10. For example, the camera 70 may be installed in a position that is in close proximity to the inner surface of the side wall 12 of the chamber 10. Fig. 3 is a diagram schematically showing how the camera 70 captures an image. In the present embodiment, a rectangular region that includes the nozzle head 412 and the substrate W supported by the spin base 21 is assumed to be an image capture region A of the camera 70. In the operation of ejecting the processing liquid from the nozzle head 412 to the surface of the substrate W, the camera 70 captures a moving image of this operation performed within the image capture region A. Then, the camera 70 transmits the captured moving image M to the controller 80.

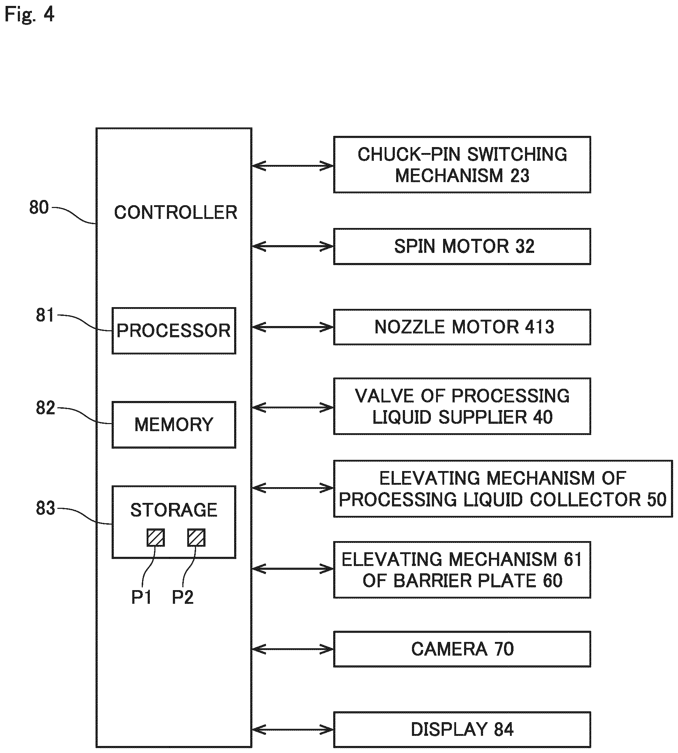

The controller 80 is means for controlling operations of each constituent element of the processing unit 102. Fig. 4 is a block diagram showing electrical connection between the controller 80 and each constituent element of the processing unit 102. As schematically shown in Fig. 4, the controller 80 is configured as a computer that includes a processor 81 such as a CPU, memory 82 such as RAM, and a storage 83 such as a hard disk drive.

The storage 83 stores an operation control program P1 and an operation monitoring program P2. The operation control program P1 is a computer program for controlling operations of each constituent element in the processing unit 102 in order to allow the processing unit 102 to perform processing on the substrate W. The operation monitoring program P2 is a computer program for monitoring and evaluating a specific operation performed in the processing unit 102 in accordance with the moving image M captured by the camera 70. The operation control program P1 and the operation monitoring program P2 are read out from a computer-readable storage medium such as a CD or a DVD and stored in the storage 83. Alternatively, the operation control program P1 and the operation monitoring program P2 may be downloaded into the controller 80 via a network.

As shown in Fig. 4, the controller 80 is communicably connected via a cable or wirelessly to each of the aforementioned constituent elements including the chuck-pin switching mechanism 23, the spin motor 32, the nozzle motor 413, the valve of the processing liquid supplier 40, the elevating mechanism of the processing liquid collector 50, the elevating mechanism 61 of the barrier plate 60, and the camera 70. The controller 80 is also electrically connected to a display 84 such as a liquid crystal display. The controller 80 controls the operations of the above-described constituent elements in accordance with the operation control program P1 and the operation monitoring program P2, which are stored in the storage 83. In this way, processing in steps S1 to S5 and in steps S11 to S16 proceed, which will be described later.

### 3. Operations of Substrate Processing Apparatus

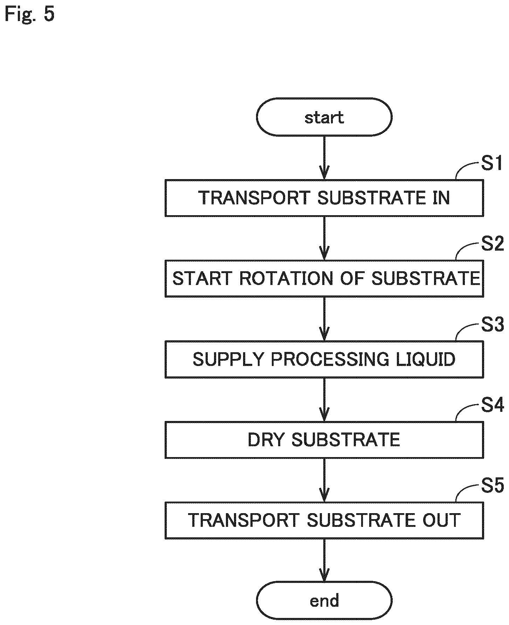

Next is a description of the processing performed on the substrate W in the processing unit 102 described above. Fig. 5 is a flowchart showing a procedure for processing the substrate W.

In the case of processing a substrate W in a processing unit 102, firstly, the main transport robot 103 transports a substrate W to be processed into the chamber 10 (step S1). The substrate W transported into the chamber 10 is horizontally held by the chuck pins 22 of the substrate holder 20. Thereafter, the spin motor 32 of the rotation mechanism 30 is driven so as to start rotation of the substrate W (step S2). Specifically, the support shaft 33, the spin base 21, the chuck pins 22, and the substrate W held by the chuck pins 22 rotate about the shaft center 330 of the support shaft 33.

Then, a processing liquid is supplied from the processing liquid supplier 40 (step S3). In step S3, the nozzle motor 413 is driven so as to move the nozzle head 412 to the processing position facing the upper surface of the substrate W. Then, the processing liquid is ejected from the nozzle head 412 placed at the processing position. The storage 83 in the controller 80 stores parameters such as an ejection rate and an ejection time of the processing liquid in advance. In accordance with these settings, the controller 80 performs the operation of ejecting the processing liquid from the top nozzle 41.

In step S3, the top nozzle 41 may swing in the horizontal direction at the processing position while ejecting the processing liquid. The processing liquid may also be ejected from the bottom nozzle 42 as necessary.

During the process of supplying the processing liquid in step S3, the barrier plate 60 is placed at the upper position above the top nozzle 41. When the supply of the processing liquid to the substrate W is completed and the top nozzle 41 is placed at the retracted position, the controller 80 operates the elevating mechanism 61 so as to move the barrier plate 60 from the upper position to the lower position. Then, the number of revolutions of the spin motor 32 is increased to enhance the speed of rotation of the substrate W, and the drying gas is issued toward the substrate W from the air outlet 62 provided in the lower surface of the barrier plate 60. In this way, the surface of the substrate W is dried (step S4).

When the dry processing of the substrate W is completed, the spin motor 32 is stopped to stop the rotation of the substrate W. Then, the chuck pins 22 release the hold of the substrate W. Thereafter, the main transport robot 103 takes the processed substrate W out of the substrate holder 20 and transports this substrate W to the outside of the chamber 10 (step S5).

Each processing unit 102 repeatedly performs the above-described processing in steps S1 to S5 on a plurality of substrates W that are transported in sequence.

### 4. Operation Monitoring

Next is a description of an operation monitoring function of the substrate processing apparatus 100. The operation monitoring function is a function of monitoring a specific operation repeatedly performed in a processing unit 102 and detecting variations in the specific operation. In the following description, the operation to be monitored is assumed to be the aforementioned operation of supplying the processing liquid in step S3. It is, however, to be noted that the operation to be monitored may be any operation other than the operation of supplying the processing liquid.

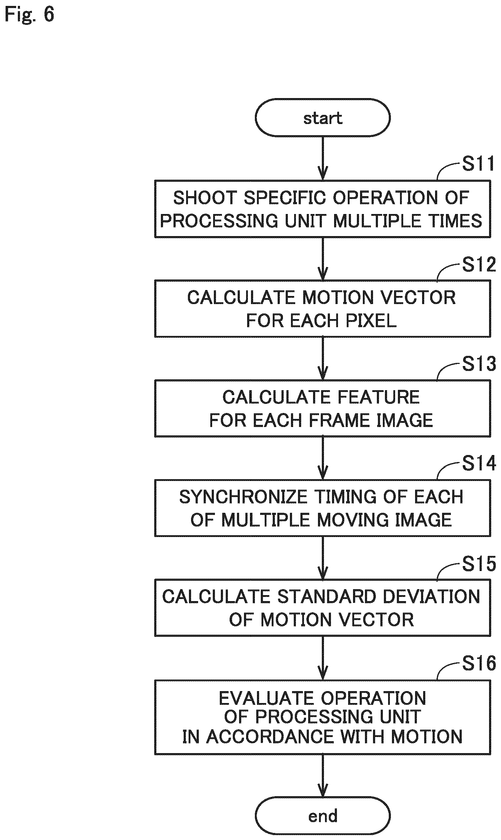

Fig. 6 is a flowchart showing the procedure for operation monitoring. The substrate processing apparatus 100 firstly performs the operation of supplying the processing liquid in step S3 multiple times. Then, the camera 70 shoots this operation multiple times (step S11). In this way, a plurality of moving images M are acquired. The operation of supplying the processing liquid as used herein may be an operation that is performed on the substrate W as a product, or may be an operation that is performed on an adjustive dummy substrate for use in adjustment of the processing unit 102. The camera 70 transmits the obtained moving images M to the controller 80. The controller 80 stores the moving images M transmitted from the cameras 70 in the storage 83.

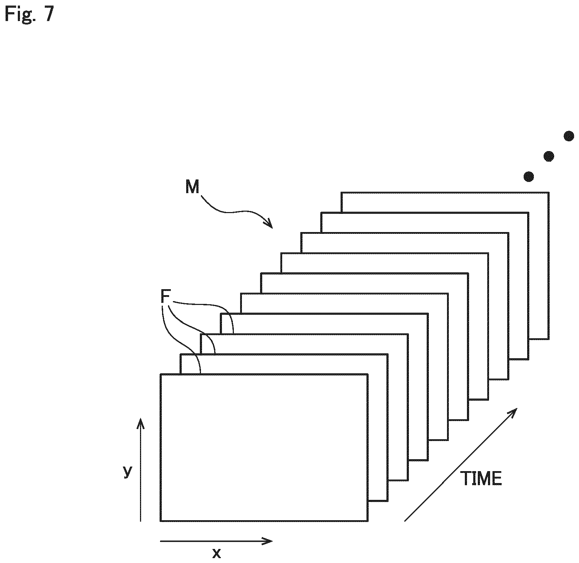

Fig. 7 is a diagram schematically showing a configuration of one moving image M. As shown in Fig. 7, the moving image M is composed of a plurality of frame images F captured at very short time intervals. Each frame image F is a two-dimensional image defined by an x axis and a y axis. Each frame image F is composed of a plurality of pixels arranged in an x-y plane and each having a pixel value (e.g., luminance value).

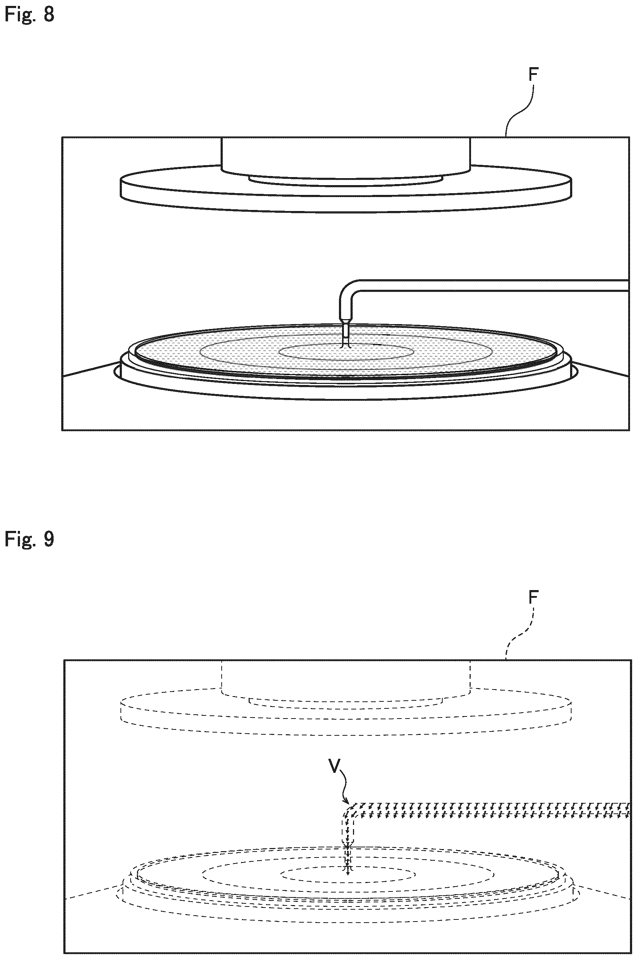

Then, the controller 80 calculates a motion vector V for each pixel by an optical flow method for a plurality of frame images F included in a plurality of moving images M (step S12). Fig. 8 is a diagram showing an example of one frame image F. Fig. 9 is a diagram showing an example of the motion vector V calculated for this frame image F. In Fig. 9, the frame image F is indicated by broken lines, and the motion vector V calculated for the frame image F is indicated by arrows overlapping the frame image F.

In step S12, the controller 80 compares the frame image F with one or a plurality of frame images F captured before or after the above frame image F in time sequence and calculates the motion vector V in accordance with the direction and magnitude of change in the position of the same pixel. The calculated motion vector V becomes information indicating the direction and magnitude of movement of components or the like included in the image capture region A. In the example in Fig. 9, a slight vibration of the top nozzle 41 attendant on the ejection of the processing liquid is reflected on the motion vector V

The controller 80 uses a so-called dense optical flow method to calculate the motion vector V for each pixel included in each frame image F. Alternatively, the controller 80 may use a so-called non-dense optical flow method to calculate the motion vector V for only some of the pixels included in each frame image F. As another alternative, the controller 80 may perform reduction processing for reducing the number of pixels in each frame image F and then use a dense optical flow method to calculate the motion vector V for each pixel in the frame image F that has undergone the reduction processing.

Then, the controller 80 calculates a feature based on the motion vector V for each frame image F of each of the moving images M (step S13). For example, the controller 80 may calculate an average value of the magnitudes (absolute values) of the motion vectors V for a plurality of pixels included in each frame image F as the feature of the frame image F. Alternatively, the controller 80 may calculate any other numerical value based on the motion vector V as the feature of each frame image F. For example, a sum of the magnitudes of the motion vectors V for a plurality of pixels included in each frame image F may be calculated as the feature of the frame image F.

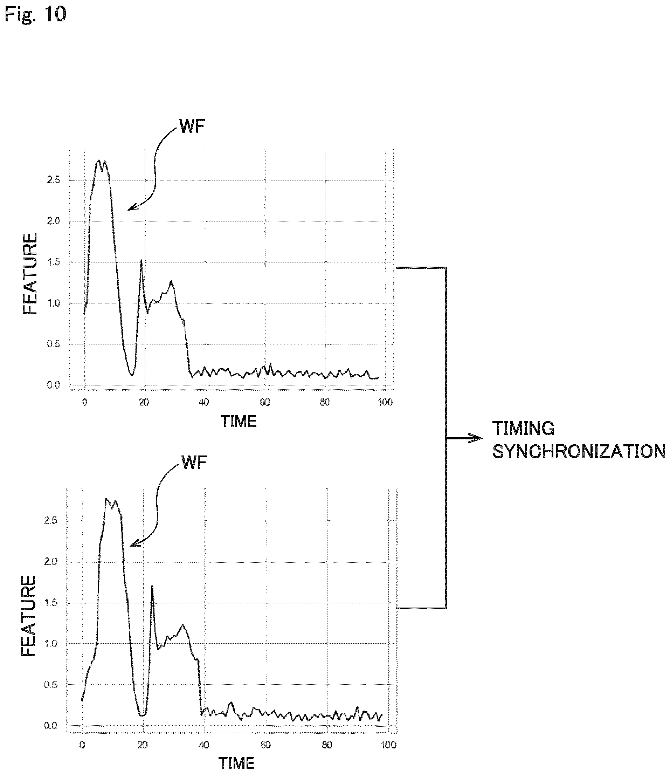

After the calculation of the feature for each frame image F of the moving images M, a time-varying waveform WF of the feature is obtained for each moving image M. Fig. 10 is a graph showing an example of the time-varying waveforms WF of the features calculated for two moving images M. In the graph in Fig. 10, the horizontal axis represents the time, and the vertical axis represents the feature.

The controller 80 synchronizes the timing of the moving images M with one another by comparing the time-varying waveforms WF of the features calculated for a plurality of moving images M (step S14). Specifically, the controller 80 obtains a cross-correlation function of the time-varying waveform WF calculated for a moving image M that serves as a reference and the time-varying waveform WF calculated for another moving image M. Then, the controller 80 obtains the amount of time deviation for which the cross-correlation function becomes a maximum value. Thereafter, the controller 80 shifts the timing of the other moving image M so as to resolve the amount of time deviation. In this way, the timing of operations in a plurality of moving images M is synchronized with the timing of the operation in the moving image M serving as a reference. That is, the same operation is conducted at the same time in the plurality of moving images M.

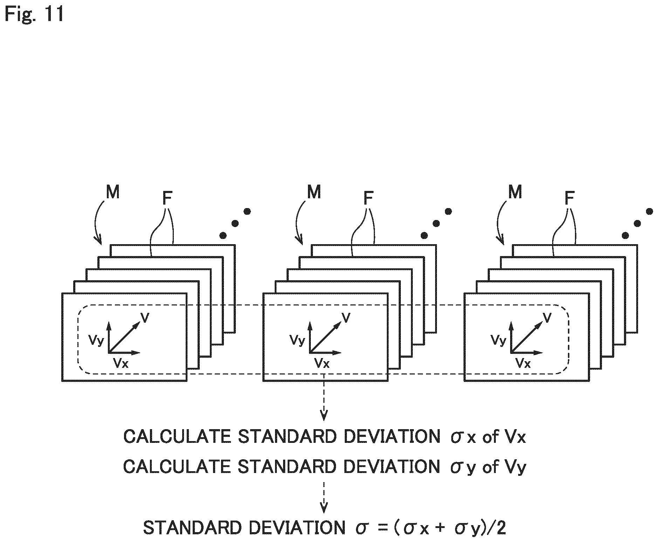

When the timing of the moving images M is synchronized with one another, then, the controller 80 calculates a standard deviation σ of the motion vector V for each pixel at each time (step S15). Fig. 11 is a diagram schematically showing the processing for calculating the standard deviations σ. As shown in Fig. 11, the controller 80 calculates the standard deviation σ of the motion vector V for each pixel by comparing motion vectors V for the same pixel at the same time in a plurality of moving images M. More specifically, the controller 80 calculates a standard deviation σx of an x-axis component Vx of the motion vector V and a standard deviation αy of a y-axis component Vy of the motion vector V. Then, the controller 80 calculates an average value of the two calculated standard deviations σx and αy as the standard deviation σ of the motion vector V for that pixel at that time.

Through the processing in step S15, the standard deviation σ of the motion vector V at each time for each pixel is calculated. This standard deviation σ becomes information indicating how much motion of components or the like at the coordinates of each pixel varies among the plurality of moving images M. The value of the standard deviation σ increases as the motion has a wider range of variations. The controller 80 records the standard deviation σ calculated for each pixel and acquires information in which the standard deviations σ are aligned in time sequence.

Then, the controller 80 evaluates the operation of the processing unit 102 in accordance with the standard deviation σ calculated in step S15 (step S16). The storage 83 of the controller 80 stores information indicating a tolerance of the standard deviation σ (e.g., a threshold value) in advance. At each time and for each pixel, the controller 80 determines whether the standard deviation σ falls within the tolerance. Then, if the standard deviation σ deviates from the tolerance, the controller 80 detects that the operation of the pixel at that time exhibits a wide range of variations.

The controller 80 displays the result of evaluation in step S16 on the display 84. The evaluation result includes information indicating the time and the pixel for which the standard deviation σ deviates from the tolerance. By checking the evaluation result displayed on the display 84, the user of the substrate processing apparatus 100 is able to confirm the time and the coordinates at which the operation exhibits a wide range of variations.

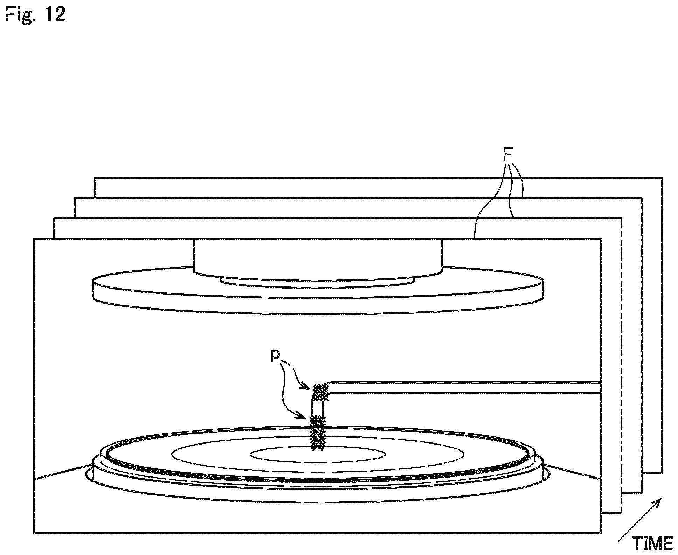

Fig. 12 is a diagram showing an example of the evaluation result. In the example in Fig. 12, frame images F are displayed as the evaluation result, and pixels whose standard deviations σ deviate from the tolerance (hereinafter, referred to as the "detected pixels P2") are highlighted in color on the display. In this way, in the case where the detected pixels P in the frame images F are displayed with a color, a character, or a graphic overlaid thereon, the user of the substrate processing apparatus 100 is able to easily and visually grasp an area where the operation exhibits a wide range of variations. Alternatively, the images of such evaluation results may be aligned in time sequence to create a moving image that shows changes in the highlighted detected pixels P over time and to display the created moving image on the display 84.

As described above, the substrate processing apparatus 100 shoots a specific operation M of the processing units 102 multiple times and calculates the motion vector V for each pixel in each frame image F of the obtained moving images M. Then, variations in the specific operation are detected in accordance with the standard deviations σ of the motion vectors V. This allows quantitative evaluation of the degree of variations in the specific operation of the processing units 102.

In particular, the operation monitoring method according to the present embodiment focuses on the motion vector V and uses the standard deviation σ of the motion vector V as the evaluation value, instead of simply comparing the values of pixels in the frame images F of a plurality of moving images M. This enables evaluating the operations of the processing units 102 as motion. Accordingly, it is possible to more appropriately evaluate the reproducibility of operations of the processing units 102.

Moreover, in the operation monitoring method according to the present embodiment, the processing for synchronizing the timing of a plurality of moving images M with one another is performed in steps S13 and S14 before the calculation of the standard deviations σ in step S 15. This allows the standard deviations σ to be calculated more accurately in step S15 in accordance with the moving images M whose timing of operations are synchronized with one another. As a result, it is possible to evaluate the operations of the processing units 102 more accurately in step S16.

In the operation monitoring method according to the present embodiment, the feature for use in synchronizing the timing of a plurality of moving images M is calculated based on the motion vector V. That is, the motion vector V for use in evaluating variations in operation is also used to synchronize the timing of the operation. This eliminates the need to measure, separately from the motion vector V, other parameters for use in synchronizing the timing of the moving images M with one another. Accordingly, it is possible to reduce measurements necessary for operation monitoring.

### 5. Variations

While one embodiment of the present invention has been described thus far, the present invention is not intended to be limited to the above-described embodiment.

### 5-1. First Variation

In the above-described embodiment, an operation repeatedly performed in a given processing unit 102 is shot to evaluate variations in the operation. However, the same operation performed in a plurality of processing units 102 may be shot to evaluate a machine-to-machine difference among the processing units 102 in accordance with the obtained moving images M.

For example, a specific operation performed in a processing unit 102 that serves as a reference and specific operations performed in other processing units 102 are shot a plurality of times. Then, the standard deviation σ is calculated for each processing unit 102 in accordance with a procedure similar to the procedure described in the above embodiment. Thereafter, if a difference in standard deviation σ between the processing unit 102 serving as a reference and any of the other processing units 102 deviates from a preset tolerance, an evaluation result is output to indicate that the operation performed in the other processing unit 102 exhibits a wide range of variations.

### 5-2. Second Variation

In the above-described embodiment, the standard deviation σ of the motion vector V obtained by using, as a population, the motion vectors calculated for the same pixel at the same time in a plurality of moving images M is assumed to be the evaluation value that represents variations in operation. It is, however, noted that the evaluation value representing variations in operation may be a value calculated in accordance with the motion vector V by a different calculation method. For example, a dispersive value of the motion vector V may be used instead of the standard deviation σ.

### 5-3. Other Variations

The above-described embodiment gives an example of evaluating an operation of a processing unit 102 that supplies a processing liquid to the surfaces of the substrates W. However, the processing unit to be evaluated may be any other unit that performs different processing on the substrates W. The objects to be processed may also be any substance other than the substrates W. The operation monitoring method according to the present invention is widely applicable to apparatuses for performing processing that involves motion.

However, in apparatuses that supply a processing liquid to the substrates W such as semiconductor wafers for use in precision electronic components, it is necessary to extremely accurately manage the reproducibility of operations. Therefore, in particular, there is a high significance of applying the operation monitoring method according to the present invention to the apparatuses that supply the processing liquid to the substrates W.

### [Reference Signs List]

- 10: chamber
- 20: substrate holder
- 30: rotation mechanism
- 40: processing liquid supplier
- 50: processing liquid collector
- 60: barrier plate
- 70: camera
- 80: controller
- 84: display
- 100: substrate processing apparatus
- 102: processing unit
- P1: operation control program
- P2: operation monitoring program
- W: substrate
- A: image capture region
- M: moving image
- F: frame image
- p: detected pixel
- V: motion vector
- WF: time-varying waveform of feature
- σ: standard deviation

## Claims

1. An operation monitoring method of monitoring an operation of a processing unit,
the operation monitoring method comprising:
a) acquiring a plurality of moving images by shooting, a plurality of times, a specific operation of the processing unit;
b) calculating a motion vector for each pixel by an optical flow for a plurality of frame images included in the plurality of moving images;
c) calculating an evaluation value based on the motion vector for each pixel by comparting the motion vectors calculated for the same pixel at the same time in the plurality of moving images; and
d) evaluating the specific operation of the processing unit in accordance with the evaluation value.

2. The operation monitoring method according to claim 1, wherein
the evaluation value is a standard deviation of the motion vector obtained by using, as a population, the motion vectors calculated for the same pixel at the same time in the plurality of moving images.

3. The operation monitoring method according to claim 2, wherein
the plurality of frame images are two-dimensional images defined by an x axis and a y axis,
the operation c) includes calculating a standard deviation of an x-axis component of the motion vector and a standard deviation of a y-axis component of the motion vector, and
in the operation d), the specific operation of the processing unit is evaluated in accordance with an average value of the standard deviation of the x-axis component and the standard deviation of the y-axis component.

4. The operation monitoring method according to any one of claims 1 to 3, further comprising:
x) calculating a feature based on the motion vector for each of the plurality of frame images in each of the plurality of moving images; and
y) synchronizing timing of the plurality of moving images with one another in accordance with a time-varying waveform of the feature,
the operation x) and the operation y) being performed after the operation b) and before the operation c).

5. The operation monitoring method according to claim 4, wherein
the feature is an average value of lengths of the motion vectors for a plurality of pixels included in the plurality of frame images.

6. The operation monitoring method according to any one of claims 1 to 5, wherein
the operation d) includes, when the evaluation value deviates from a preset tolerance, outputting an evaluation result indicating that the specific operation exhibits a wide range of variations.

7. The operation monitoring method according to any one of claims 1 to 5, wherein
in the operation a), the plurality of moving images are acquired by shooting, the plurality of times, the specific operation for each of a processing unit that serves as a reference and a different processing unit, and
the operation d) includes, when a difference between the evaluation value calculated for the processing unit serving as the reference and the evaluation value calculated for the different processing unit deviates from a preset tolerance, outputting an evaluation result indicating that the specific operation of the different processing unit exhibits a wide range of variations.

8. The operation monitoring method according to claim 6 or 7, wherein
in the outputting of the evaluation result, a pixel whose evaluation value deviates from the preset tolerance in the plurality of frame images is displayed with a color, a character, or a graphic overlaid on the pixel.

9. The operation monitoring method according to any one of claims 1 to 8, wherein
the processing unit is a unit that supplies a processing liquid to a surface of a substrate.

10. A manufacturing apparatus comprising:
a processing unit that processes a target object by performing a specific operation;
a camera that captures a moving image of the specific operation of the processing unit; and
a computer that evaluates the specific operation in accordance with the moving image obtained from the camera,
the manufacturing apparatus causing the computer to execute:
a) processing for acquiring a plurality of moving images by causing the camera to shoot, a plurality of times, the specific operation of the processing unit;
b) processing for calculating a motion vector for each pixel by an optical flow method for a plurality of frame images included in the plurality of moving images;
c) processing for calculating an evaluation value in accordance with the motion vector for each pixel by comparing the motion vectors calculated for the same pixel at the same time in the plurality of moving images; and
d) processing for evaluating the specific operation of the processing unit in accordance with the evaluation value.
